# FASCICULE DE BREVET EUROPEEN

(11) **EP 1 672 316 B1**
(45) Date de publication et mention de la délivrance du brevet: **16.04.2008**
(21) Numéro de dépôt: 04106714.1
(22) Date de dépôt: 20.12.2004
(51) Int. Cl.: G01C 19/56, H03H 9/21

(54) **Transducteur de mesure d'une vitesse angulaire**
Messwertgeber zur Drehgeschwindigkeitsmessung
Transducer for measuring angular speed

(43) Date de publication de la demande: 21.06.2006
(73) Titulaire: ETA SA Manufacture Horlogère Suisse, 2540 Grenchen (CH)
(72) Inventeur: Dalla Piazza, Silvio, 2610, Saint-Imier (CH); Studer, Bruno, 4533, Riedholz (CH)
(74) Mandataire: Vigand, Philippe

(56) Documents cités:
- EP-A- 0 494 588
- EP-A- 0 750 177
- US-A- 4 930 351

## Description

### DOMAINE TECHNIQUE

La présente invention concerne, de manière générale, un transducteur de mesure d'une vitesse angulaire formé par un unique diapason piézoélectrique destiné à tourner à ladite vitesse angulaire comprenant une base depuis laquelle s'étendent une branche d'excitation et une branche de détection, et concerne plus particulièrement l'agencement des électrodes de détection disposées sur la branche de détection.

### ARRIERE-PLAN TECHNOLOGIQUE

Il est connu dans l'art antérieur, notamment du document EP 0 750 177 ou encore du document EP 0 494 588, un gyromètre formé par un unique diapason présentant une base depuis laquelle s'étendent une première branche sur laquelle sont disposées des électrodes d'excitation et une deuxième branche sur laquelle sont disposées des électrodes de détection.

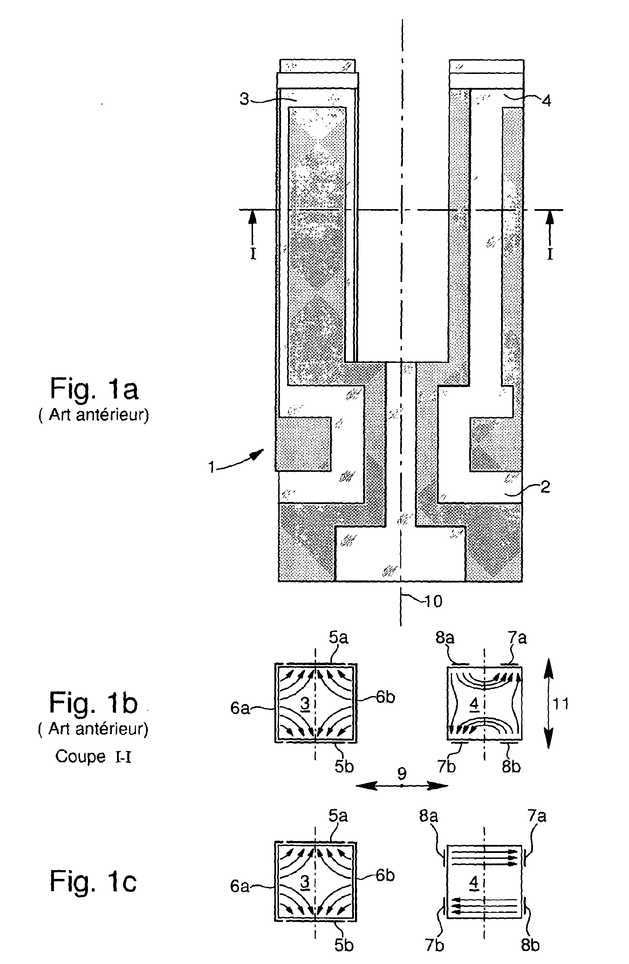

Sur la figure 1 est représenté un exemple de diapason 1 du type de ceux utilisables dans un gyromètre. Le diapason 1 représenté en coupe longitudinale dans la figure 1a comporte principalement une base 2 solidaire de deux branches 3, 4, l'ensemble étant réalisé en un matériau de quartz piézo-électrique. Comme représenté en coupe transversale selon la figure 1b, chaque branche 3, 4 comporte des électrodes. La branche d'excitation 3 comporte une première paire d'électrodes d'excitation 5a, 5b connectées ensemble et sur lesquelles est appliqué un signal électrique alternatif à la fréquence de résonance du diapason dans son plan principal correspondant à celui de la figure 1a, et une deuxième paire d'électrodes d'excitation 6a, 6b connectées ensemble et sur lesquelles est appliqué un signal électrique alternatif en opposition de phase de celui appliqué sur les électrodes 5a et 5b. L'application de ces signaux électriques alternatifs permet d'exciter et par conséquent de faire vibrer mécaniquement les branches 3, 4 du diapason 1 dans un premier plan, comme indiqué par les flèches 9. La branche de détection 4 comporte une première paire d'électrodes de détection 7a, 7b connectées ensemble et une deuxième paire d'électrodes de détection 8a, 8b connectées ensemble, paires qui permettent de transformer les vibrations mécaniques de la branche de détection en un signal électrique détecté au moyen d'un circuit de détection auxquelles ces électrodes sont reliées.

Selon la théorie des gyromètres à diapason, pendant qu'un signal d'excitation est appliqué sur les électrodes d'excitation 5a-5b, 6a-6b, un mouvement en rotation angulaire du diapason 1 autour de son axe longitudinal 10 génère une force de Coriolis perpendiculaire à la vitesse de la branche excitée et à l'axe de rotation 10, et par conséquent, une vibration dans la branche de détection 4 dans un plan perpendiculaire au plan correspondant à la vibration d'excitation, comme indiqué par les flèches 11. Cette vibration mécanique est transformée par le quartz piézo-électrique du diapason 1 en un signal électrique qui est détecté par les électrodes de détection 7a-7b, 8a-8b du diapason.

L'un des principaux problèmes observé avec une telle disposition d'électrodes de détection, réside dans le fait que le chemin électrique du champ à détecter entre deux électrodes de détection sur lesquelles un signal électrique opposé est appliqué, n'est pas rectiligne, et par conséquent une partie non négligeable des lignes de champ est perdue. De ce fait, la mesure de détection n'est pas optimale.

Une solution théoriquement intéressante consisterait à disposer les deux paires d'électrodes de détection 7a-7b, 8a-8b, tel que cela est représenté à la figure 1c. Toutefois, cette solution présente un inconvénient majeur, dans la mesure où elle nécessite la mise en oeuvre d'un procédé de fabrication complexe et difficilement maîtrisable. En effet, les électrodes présentes sur les faces latérales du diapason sont réalisées par un "dépôt d'électrode", lequel est forcément réalisé sur toute l'épaisseur de la face latérale. Ainsi, il est alors très difficile de pouvoir séparer le dépôt d'électrode en deux, de manière à obtenir les deux électrodes 7b, 8a distinctes souhaitées. De plus, ce genre de gyromètre est réalisé en série, c'est-à-dire les uns à côté des autres. Aussi, il est également très difficile de séparer le dépôt d'électrode effectué sur les faces latérales extérieures du diapason en deux électrodes 7a, 8b distinctes.

De plus, les différentes solutions susmentionnées présentent un inconvénient supplémentaire, à savoir, la taille du diapason, qui pour de telles applications gyromètres embarqués doivent bien entendu être avantageusement le plus miniaturisés possible.

### RESUME DE L'INVENTION

L'un des buts principaux de la présente invention est de pallier aux inconvénients susmentionnés en réalisant un transducteur de mesure d'une vitesse angulaire sous forme d'un résonateur piézo-électrique à diapason présentant une structure d'électrodes de détection assurant une mesure optimisée du champ électrique créé dans la branche de détection tout en utilisant un procédé de fabrication simple à mettre en oeuvre.

A cet effet, dans le cadre de la présente invention, il est prévu d'agencer les électrodes de détection de manière à ce que, d'une part, leur procédé de fabrication soit simple et que, d'autre part, les lignes de champ électrique détectées dans la branche de détection parcourent un chemin électrique sensiblement rectiligne entre les électrodes opposées au travers de la branche de détection. Pour cela, il est en particulier prévu des protubérances sur les faces latérales de la branche de détection du diapason afin de séparer facilement les électrodes de détection disposées au niveau de la partie supérieure de celles disposées au niveau de la partie inférieure de la branche.

Dans ce but, l'invention concerne selon un mode préféré de réalisation, un transducteur de mesure d'une vitesse angulaire selon le préambule de la description caractérisé en ce que la branche de détection présente une section en forme de croix comprenant deux faces latérales supérieures et deux faces latérales inférieures, les faces supérieures et inférieures étant séparées par des protubérances faisant saillie par rapport aux faces supérieures et inférieures et en ce que les moyens de détection comprennent des première et deuxième électrodes de détection disposées en regard l'une à l'autre, chacune étant agencées sur une des faces latérales supérieures, de sorte que le champ électrique entre les première et deuxième électrodes de détection soit sensiblement rectiligne au travers de la branche de détection, et des troisième et quatrième électrodes de détection disposées en regard l'une à l'autre, chacune étant agencée sur une des faces latérales inférieures de sorte que le champ électrique entre les troisième et quatrième électrodes de détection soit sensiblement rectiligne au travers de la branche de détection.

Toujours dans un souci de miniaturisation, il est prévu avantageusement des moyens de découplage mécanique au niveau de la base du diapason, permettant ainsi de réduire encore la taille de celle-ci.

### BREVE DESCRIPTION DES FIGURES

D'autres caractéristiques et avantages de la présente invention apparaîtront plus clairement à la lecture de la description détaillée qui suit de modes de réalisation de l'invention donnés uniquement à titre d'exemple non limitatif et illustrés par les dessins annexés où :
- la figure 1a, déjà décrite, est une vue en coupe longitudinale d'un diapason tel que ceux utilisés dans certains gyromètres selon l'art antérieur ;
- la figure 1b, déjà décrite, est une vue en coupe transversale I-I des branches d'excitation et de détection du diapason de la figure 1a ;
- la figure 1c, déjà décrite, est une vue en coupe transversale des branches d'excitation et de détection d'un diapason avec une disposition optimisée des électrodes de détection ;
- la figure 2a est une vue en coupe longitudinale d'un diapason pour gyromètre selon un premier mode de réalisation de l'invention ;
- la figure 2b est une vue agrandie en coupe transversale II-II des branches d'excitation et de détection du diapason selon la figure 2a ;
- la figure 2c est une vue agrandie en coupe transversale des deux branches d'un diapason selon une variante du premier mode de réalisation de l'invention ;
- la figure 3a est une vue agrandie en coupe transversale des branches d'excitation et de détection d'un diapason selon un deuxième mode de réalisation selon l'invention ;
- la figure 3b est une vue agrandie en coupe transversale des branches d'excitation et de détection d'un diapason selon une variante du deuxième mode de réalisation selon l'invention.

### DESCRIPTION DETAILLEE DE L'INVENTION

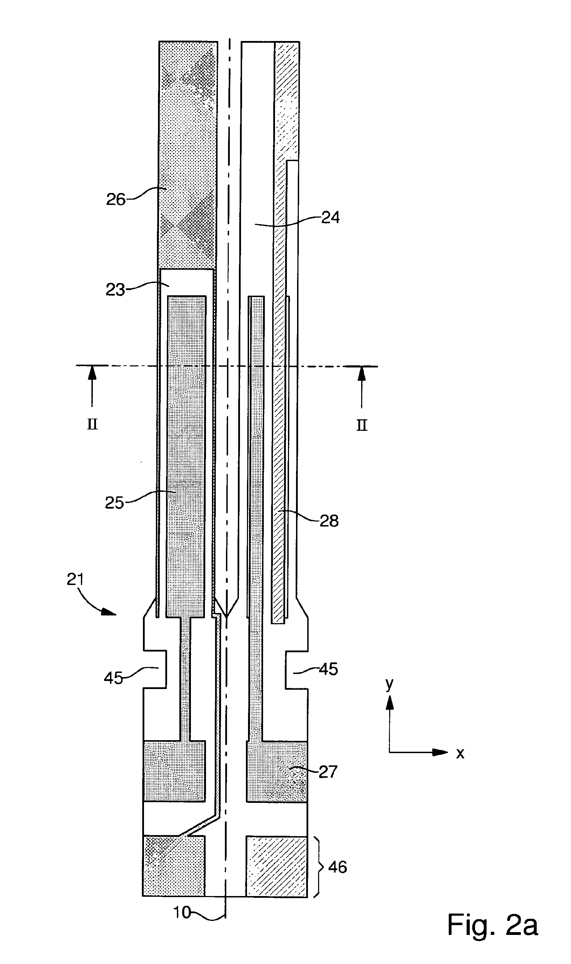

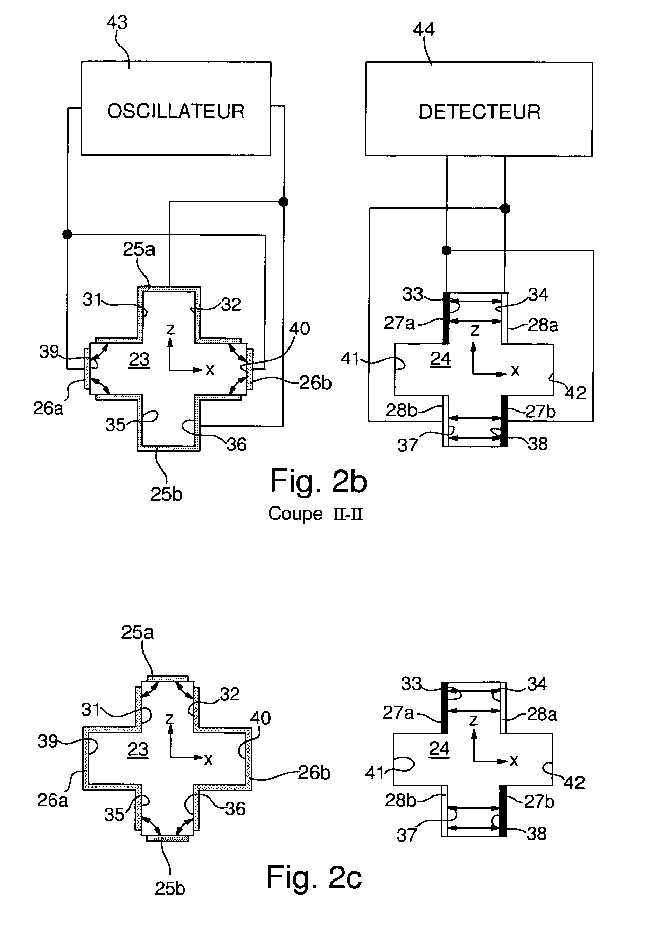

Conformément à un premier mode de réalisation de l'invention représenté sur les figures 2a et 2b, le dispositif de mesure d'une vitesse angulaire comprend un transducteur formé par un unique diapason 21 piézoélectrique, classiquement en quartz, destiné à tourner à la vitesse angulaire, formé par une base 22 depuis laquelle s'étendent deux branches parallèles 23, 24 séparées par une fente, qui portent chacun des dépôts conducteurs formant des électrodes de polarités opposées qui permettent de créer et de détecter dans les branches un champ électrique alternatif provoquant et provoqué par la vibration du diapason par déformation piézoélectrique.

Des moyens d'excitation 25, 26 sont disposés sur une des deux branches, appelée branche d'excitation 23, pour générer en réponse à un signal d'excitation une vibration du transducteur à une fréquence déterminée, correspondant de préférence à la fréquence de résonance du diapason dans son plan X-Y, dans une première direction. Selon l'exemple représenté à la figure 2b, qui est une vue en coupe transversale selon l'axe II-II de la figure 2a, la branche d'excitation 23 présente avantageusement une section en forme de croix, comprenant deux faces latérales supérieures 31-32 et deux faces latérales inférieures 35-36, les faces supérieures et inférieures étant séparées par des protubérances 39-40 faisant saillie, de préférence sensiblement selon l'axe x, par rapport aux faces latérales supérieures et inférieures. Selon ce premier mode de réalisation, les moyens d'excitation comportent une première paire d'électrodes d'excitation 25a et 25b agencées sur le dessus et respectivement le dessous de la branche d'excitation recouvrant les faces latérales supérieures 31-32, respectivement inférieures 35-36, et une deuxième paire d'électrodes d'excitation 26a et 26b, ou électrodes latérales agencées sur toute l'épaisseur des protubérances 39 respectivement 40 de la branche d'excitation.

Les électrodes sont prévues pour être connectées électriquement d'une manière en elle-même classique, les électrodes centrales 25a et 25b à l'un des pôles de la source d'excitation et les électrodes latérales 26a et 26b au pôle opposé de la source d'excitation; ces connexions peuvent être réalisées en grande partie par des pistes conductrices déposées sur le diapason lui-même. La source d'excitation a été représentée dans l'exemple de la figure 2a schématiquement sous la forme d'un oscillateur 43. En fonctionnement, on peut ainsi entretenir les vibrations du résonateur par flexion de la branche d'excitation 23 du diapason, grâce à un champ électrique alternatif transversal dans les plans des branches 23, 24.

Des moyens de détection 27, 28 sont prévus sur l'autre branche du diapason, appelée branche de détection 24, pour produire un signal électrique de détection en réponse à une seconde vibration du transducteur, due à la première vibration et à la rotation autour de l'axe longitudinal 10, ayant la même fréquence déterminée et dans une deuxième direction perpendiculaire à la première direction. La deuxième vibration comprend une composante utile ayant une amplitude représentative de la vitesse angulaire.

Le gyromètre comprenant le diapason décrit précédemment comprend en outre un appareil de mesure adéquat, représenté schématiquement sous la forme d'un récepteur 44, qui ne sera pas décrit ici car sa constitution dépend du but dans lequel la vitesse angulaire du transducteur est mesurée, cet appareil de mesure permettant de fournir à partir du signal électrique de détection un signal de mesure représentatif de la vitesse angulaire.

Toujours, selon l'exemple représenté à la figure 2b, la branche de détection 23 présente une section en forme de croix, comprenant deux faces latérales supérieures 33-34 et deux faces latérales inférieures 37-38, les faces supérieures et inférieures étant séparées par des protubérances 41-42 faisant saillie, de préférence sensiblement selon l'axe x, par rapport aux faces latérales supérieures et inférieures.

Les moyens de détection comprennent des première 27a et deuxième 28a électrodes de détection agencées en regard l'une de l'autre, sur une face latérale supérieure 33, respectivement l'autre face latérale supérieure 34, de sorte que le chemin électrique entre les deux électrodes 27a et 28a soit sensiblement rectiligne au travers de la branche de détection 24. Les moyens de détection comprennent également des troisième 27b et quatrième 28b électrodes de détection agencées en regard l'une de l'autre, sur une face latérale inférieure 37, respectivement sur l'autre face latérale inférieure 38, de sorte que le chemin électrique entre les deux électrodes 27b et 28b soit sensiblement rectiligne au travers de la branche de détection 24. Les électrodes 27a et 27b sont connectées à un pôle du détecteur 44, et les électrodes 28a et 28b sont connectées à un autre pôle, opposé au premier, du détecteur 44. Ainsi, la détection du champ électrique produit dans la branche de détection est optimisée tout en assurant un procédé simple de dépôt des électrodes similaires à celui décrit dans le document EP 0 750 177.

Dans un souci de miniaturisation, il est avantageusement prévu des moyens de découplage mécanique 45 entre la partie de fixation 46 de la base du diapason au gyromètre et les branches vibrantes 23, 24. Ces moyens de découplage mécanique peuvent être suivant une première variante constitués par des encoches 45 pratiquées dans la partie supérieure de la base. Selon une deuxième variante, non représentée ici, ces moyens de découplage mécanique sont constitués par un trou agencé dans la partie centrale supérieure de la base 22. Une combinaison des variantes susmentionnées est également envisageable.

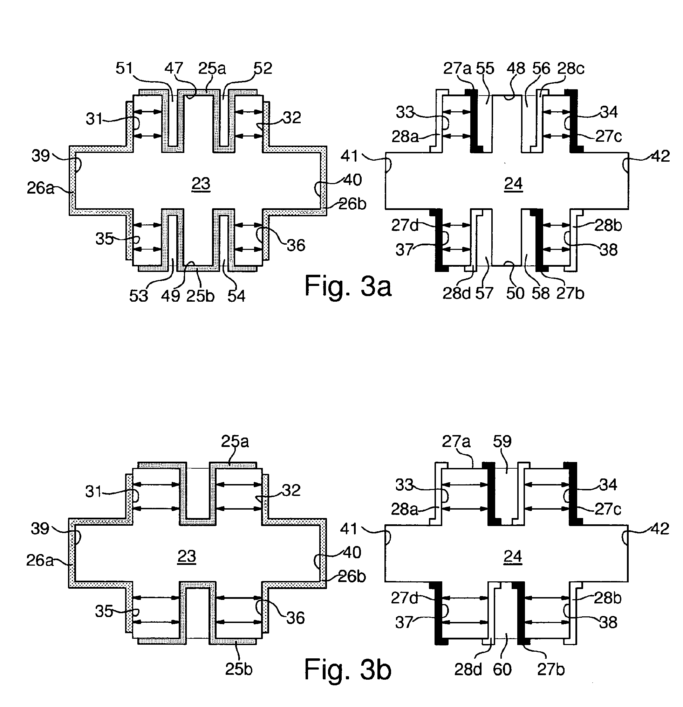

On notera que sur les figures 2c, 3a et 3b dont la description va suivre, l'oscillateur 43 et le détecteur 44 n'ont pas été représentés de nouveau dans un souci de simplification.

La figure 2c représente une variante de réalisation du diapason décrit en rapport avec les figures 2a et 2b. Cette variante se distingue du premier mode de réalisation par rapport à la disposition des électrodes d'excitation sur la branche d'excitation 23.

Selon cette variante de réalisation, il est prévu de manière alternative que les moyens d'excitation comportent une première paire d'électrodes d'excitation 25a et respectivement 25b agencées sur le dessus et respectivement le dessous de la branche d'excitation sans recouvrir les faces latérales supérieures 31-32, respectivement inférieures 35-36, et une deuxième paire d'électrodes d'excitation 26a et respectivement 26b, ou électrodes latérales agencées sur toute l'épaisseur des protubérances 39 respectivement 40 de la branche d'excitation ainsi que recouvrant au moins partiellement les faces latérales supérieure 31 et inférieure 35, respectivement supérieure 32 et inférieure 36.

La figure 3a représente une vue en coupe transversale d'un diapason pour gyromètre selon un deuxième mode de réalisation de l'invention. Les branches d'excitation 23 et de détection 24 présentent chacune une section sensiblement en forme de croix, comprenant deux faces latérales supérieures 31-32, respectivement 33-34 et deux faces latérales inférieures 35-36, respectivement 37-38, les faces supérieures et inférieures étant séparées par des protubérances 39-40, respectivement 41-42 faisant saillie, de préférence sensiblement selon l'axe x, par rapport aux faces latérales supérieures et inférieures. Chacune des deux branches comprend une face supérieure 47, respectivement 48, et une face inférieure 49, respectivement 50, situées de préférence sensiblement dans le plan X, Y.

Dans l'exemple représenté à la figure 3a, la branche d'excitation 23 comprend deux rainures 51-52 gravées sur sa face supérieure 47 et deux rainures 53-54 gravées sur sa face inférieure 49. Toutefois, il est envisageable à titre d'alternative de ne prévoir qu'une seule rainure sur chacune des faces supérieure et inférieure.

Les moyens d'excitation comportent une première électrode d'excitation 25a agencée sur la face supérieure 47, de manière à recouvrir transversalement les rainures 51-52 et une deuxième électrode d'excitation 25b agencée sur la face inférieure 49, de manière à recouvrir transversalement les rainures 53-54. Les moyens d'excitation comprennent encore des troisième 26a et quatrième 26b électrodes d'excitation, ou électrodes latérales connectées à un potentiel opposé celui auquel sont connectées les deux premières électrodes 25a et 25b, et agencées sur toute l'épaisseur des protubérances 39 respectivement 40 de la branche d'excitation ainsi que recouvrant au moins partiellement les faces latérales supérieure 31 et inférieure 35, respectivement supérieure 32 et inférieure 36.

La branche de détection 24 comprend de la même manière deux rainures 55-56 gravées sur sa face supérieure 48 et deux rainures 57-58 gravées sur sa face inférieure 50. Chacune des rainures 55-58 présentant des flancs latéraux. Toutefois, comme pour la branche d'excitation, il est envisageable à titre d'alternative de ne prévoir qu'une seule rainure sur chacune des faces supérieure et inférieure. On notera encore que la prévision de rainures sur les deux faces donne une section de branche symétrique, ce qui évite des déformations de ces branches en dehors de leur plan. La présence des rainures favorise la création d'un champ électrique homogène selon l'axe électrique X du cristal.

Toujours selon l'exemple de la figure 3a, les moyens de détection comportent une première paire d'électrodes de détection 27a-28a agencées en regard l'une de l'autre, l'électrode 28a étant agencée sur la face latérale supérieure 33, l'autre électrode 27a étant agencée sur l'un des flancs latéraux de la rainure 55 de sorte que le champ électrique entre les deux électrodes 27a et 28a soit sensiblement rectiligne au travers de la branche 24, et une troisième paire d'électrodes de détection 27c-28c agencées en regard l'une de l'autre, l'électrode 27c étant agencée sur la face latérale supérieure 34 et l'autre électrode 28c étant agencée sur l'un des flancs latéraux de la rainure 56 de sorte que le champ électrique entre les deux électrodes 27c et 28c soit sensiblement rectiligne au travers de la branche de détection 24. De manière symétrique, les moyens de détection comprennent une deuxième paire d'électrodes de détection 27b-28b agencées en regard l'une de l'autre, l'électrode 28b étant agencée sur la face latérale inférieure 38, l'autre électrode 27b étant agencée sur l'un des flancs latéraux de la rainure 58 de sorte que le champ électrique entre les deux électrodes 27b et 28b soit sensiblement rectiligne au travers de la branche 24, et une quatrième paire d'électrodes de détection 27d-28d agencées en regard l'une de l'autre, l'électrode 27d étant agencée sur la face latérale inférieure 37 et l'autre électrode 28d étant agencée sur l'un des flancs latéraux de la rainure 57 de sorte que le champ électrique entre les deux électrodes 27d et 28d soit sensiblement rectiligne au travers de la branche de détection 24.

Selon ce deuxième mode de réalisation, les rainures 55-58 creusées longitudinalement sur chacune des faces supérieure et inférieure des branches d'excitation et de détection, ont une profondeur comprise entre 20% et 45% de l'épaisseur des branches, et préférentiellement de l'ordre de 30%.

La disposition des électrodes dans des rainures gravées dans l'épaisseur des branches augmente le couplage piézo-électrique. A dimensions égales, cette augmentation entraîne une diminution de la résistance équivalente du diapason, et donc une diminution de la consommation de l'oscillateur qui lui est associé, car à facteur de qualité égal, cette disposition permet de réduire les dimensions du résonateur.

Selon une variante de ce deuxième mode de réalisation, représentée à la figure 3b, les branches d'excitation et de détection ne comprennent qu'une seule rainure sur chacune des faces supérieure et inférieure. Dans ce cas, les électrodes d'excitation disposées sur les faces supérieure et inférieure de la branche d'excitation recouvrent transversalement la rainure correspondante. Concernant les moyens de détection, ils comprennent une première paire d'électrodes de détection 27a-28a, agencées en regard l'une de l'autre, l'électrode 28a étant agencée sur la face latérale supérieure 33, l'autre électrode 27a étant agencée sur l'un des flancs latéraux de la rainure 59 de sorte que le champ électrique entre les deux électrodes 27a et 28a soit sensiblement rectiligne au travers de la branche 24, et une troisième paire d'électrodes de détection 27c-28c agencées en regard l'une de l'autre, l'électrode 27c étant agencée sur la face latérale supérieure 34 et l'autre électrode 28c étant agencée sur l'autre des flancs latéraux de la rainure 59 de sorte que le champ électrique entre les deux électrodes 27c et 28c soit sensiblement rectiligne au travers de la branche de détection 24. De manière symétrique, les moyens de détection comprennent une deuxième paire d'électrodes de détection 27b-28b agencées en regard l'une de l'autre, l'électrode 28b étant agencée sur la face latérale inférieure 38, l'autre électrode 27b étant agencée sur l'un des flancs latéraux de la rainure 60 de sorte que le champ électrique entre les deux électrodes 27b et 28b soit sensiblement rectiligne au travers de la branche 24, et une quatrième paire d'électrodes de détection 27d-28d agencées en regard l'une de l'autre, l'électrode 27d étant agencée sur la face latérale inférieure 37 et l'autre électrode 28d étant agencée sur l'autre des flancs latéraux de la rainure 60 de sorte que le champ électrique entre les deux électrodes 27d et 28d soit sensiblement rectiligne au travers de la branche de détection 24.

On notera qu'avantageusement, comme cela a été représenté sur les figures 2b, 2c et 3a et 3b, le diapason piézoélectrique est un quartz dont les faces principales, supérieure et inférieure, sont sensiblement perpendiculaires à l'axe optique (z) du quartz et en ce que les branches s'étendent sensiblement selon l'axe mécanique (y) du quartz.

On comprendra que diverses modifications et / ou améliorations évidentes pour l'homme du métier peuvent être apportées aux différentes modes de réalisation de l'invention décrits dans la présente description, notamment on notera que les branches de détection et d'excitation peuvent être interverties, la branche d'excitation servant alors de branche de détection et vice versa, que les moyens de découplage mécanique peuvent être utilisés pour chacun des modes de réalisation sus présentés, que les solutions dites diapason à électrodes croisées, dans lesquelles des paires d'électrodes d'excitation et de détection sont inversées entre les deux branches, sont possibles, et cela sans sortir du cadre de l'invention défini par les revendications annexées.

## Revendications

1. Transducteur de mesure d'une vitesse angulaire formé par:
- un unique diapason piézoélectrique (21) destiné à tourner à ladite vitesse angulaire ;
- ledit diapason comprenant des première (23) et seconde (24) branches vibrantes s'étendant depuis une base (22);
- des moyens d'excitation (25a, 25b, 26a, 26b) d'une première vibration du diapason, disposés sur une des deux branches, appelée branche d'excitation (23) ;
- des moyens de détection (27a, 27b, 28a, 28b) d'une deuxième vibration du diapason produite en réponse à la première vibration et à une rotation du diapason, disposés sur l'autre des deux branches, appelée branche de détection (24) ;
**caractérisé en ce que** ladite branche de détection (24) présente une section en forme de croix comprenant deux faces latérales supérieures (33, 34) et deux faces latérales inférieures (37, 38), lesdites faces supérieures et inférieures étant séparées par des protubérances (41, 42) faisant saillie par rapport aux dites faces supérieures et inférieures, et
**en ce que** lesdits moyens de détection comprennent des première (27a) et deuxième (28a) électrodes de détection disposées en regard l'une à l'autre, chacune étant agencées sur une des faces latérales supérieures (33, 34), de sorte que le champ électrique entre les première et deuxième électrodes de détection soit sensiblement rectiligne au travers de la branche de détection, et des troisième (27b) et quatrième (28b) électrodes de détection disposées en regard l'une à l'autre, chacune étant agencée sur une des faces latérales inférieures (37, 38) de sorte que le champ électrique entre les troisième et quatrième électrodes de détection soit sensiblement rectiligne au travers de la branche de détection.

2. Transducteur de mesure d'une vitesse angulaire selon la revendication 1, **caractérisé en ce que** ladite branche d'excitation (23) présente une section en forme de croix comprenant deux faces latérales supérieures (31, 32) et deux faces latérales inférieures (35, 36), lesdites faces supérieures et inférieures étant séparées par des première (39) et deuxième (40) protubérances faisant saillie par rapport aux dites faces supérieures et inférieures, et
**en ce que** lesdits moyens d'excitation comprennent une première paire d'électrodes d'excitation (25a, 25b) agencées dessus, respectivement dessous, la branche d'excitation recouvrant les faces latérales supérieures (31, 32), respectivement inférieures (35, 36), et une deuxième paire d'électrodes d'excitation (26a, 26b), chacune des électrodes de ladite deuxième paire étant agencée sur toute l'épaisseur de l'une (39), respectivement de l'autre (40), protubérance de la branche d'excitation.

3. Transducteur de mesure d'une vitesse angulaire selon la revendication 1, **caractérisé en ce que** ladite branche d'excitation (23) présente une section en forme de croix comprenant deux faces latérales supérieures (31, 32) et deux faces latérales inférieures (35, 36), lesdites faces supérieures et inférieures étant séparées par des première (39) et deuxième (40) protubérances faisant saillie par rapport aux dites faces supérieures et inférieures, et
**en ce que** lesdits moyens d'excitation comprennent une première paire d'électrodes d'excitation (25a, 25b) agencées dessus, respectivement dessous, la branche d'excitation sans recouvrir les faces latérales supérieures (31, 32), respectivement inférieures (35, 36), et une deuxième paire d'électrodes d'excitation (26a, 26b) chacune des électrodes de ladite deuxième paire étant agencée sur toute l'épaisseur de l'une (39), respectivement de l'autre (40), protubérance de la branche d'excitation ainsi que recouvrant au moins partiellement les faces latérales supérieure (31) et inférieure (35) disposées de part et d'autre de la première protubérance (39), respectivement les faces latérales supérieure (32) et inférieure (36) disposées de part et d'autre de la deuxième protubérance (40).

4. Transducteur de mesure d'une vitesse angulaire selon l'une des revendications 1 à 3, **caractérisé en ce que** ladite section en forme de croix de la branche de détection présente une face supérieure (48) reliant les deux faces latérales supérieures (33, 34) et une face inférieure (50) reliant les deux faces latérales inférieures (37, 38),
**en ce que** lesdites faces supérieure et inférieure présentent chacune au moins une rainure (55, 58; 59, 60), lesdites rainures présentant des flancs latéraux,
**en ce qu'**au moins l'une (27a) des électrodes de ladite première paire d'électrodes de détection est agencée sur l'un des flancs latéraux de ladite au moins une rainure (55; 59) de la face supérieure de sorte que le champ électrique entre les deux électrodes (27a, 28a) soit sensiblement rectiligne au travers de la branche de détection, et
**en ce qu'**au moins l'une (27b) des électrodes de la deuxième paire d'électrodes de détection est agencée sur l'un des flancs latéraux de ladite au moins une rainure (58; 60) de la face inférieure de sorte que le champ électrique entre les deux électrodes (27b, 28b) soit sensiblement rectiligne au travers de la branche de détection 24.

5. Transducteur de mesure d'une vitesse angulaire selon la revendication 4, **caractérisé en ce que** chacune desdites faces supérieure (48) et inférieure (50) comprend une seule rainure (59, 60),
**en ce que** lesdits moyens de détection comprennent en outre une troisième paire (27c, 28c) d'électrodes de détection agencées en regard l'une de l'autre, l'une (28c) des électrodes de la troisième paire étant agencée sur l'autre des flancs latéraux de ladite rainure (59) de la face supérieure, l'autre (27c) des électrodes de la troisième paire étant agencée sur la face latérale supérieure (34) de sorte que le champ électrique entre les deux électrodes (27c, 28c) soit sensiblement rectiligne au travers de la branche de détection 24, et
**en ce que** les moyens de détection comprennent en outre une quatrième paire d'électrodes de détection (27d, 28d) agencées en regard l'une de l'autre, l'une (28d) des électrodes de ladite quatrième paire étant agencée sur l'autre des flancs latéraux de ladite rainure de la face inférieure (60), l'autre (27d) des électrodes de ladite quatrième paire étant agencée sur la face latérale inférieure (38) de sorte que le champ électrique entre les deux électrodes (27d, 28d) soit sensiblement rectiligne au travers de la branche de détection.

6. Transducteur de mesure d'une vitesse angulaire selon la revendication 4, **caractérisé en ce que** chacune des faces supérieure (48) et inférieure (50) comprend deux rainures (55-56, 57-58),
**en ce que** les moyens de détection comprennent en outre une troisième paire d'électrodes (27c, 28c) agencées en regard l'une de l'autre, l'une (28c) des électrodes de ladite troisième paire étant agencée sur l'un des flancs latéraux de l'autre des deux rainures (56) de la face supérieure, l'autre (27c) des électrodes de ladite troisième paire étant agencée sur la face latérale supérieure (34) de sorte que le champ électrique entre les deux électrodes (27c, 28c) soit sensiblement rectiligne au travers de la branche de détection, et
**en ce que** les moyens de détection comprennent en outre une quatrième paire d'électrodes de détection (27d, 28d) agencées en regard l'une de l'autre, l'une (28d) des électrodes de ladite quatrième paire étant agencée sur l'un des flancs latéraux de l'autre des deux rainures (57) de la face inférieure, l'autre (27d) des électrodes de ladite quatrième paire étant agencée sur la face latérale inférieure (37) de sorte que le champ électrique entre les deux électrodes (27d, 28d) soit sensiblement rectiligne au travers de la branche de détection.

7. Transducteur de mesure d'une vitesse angulaire selon l'une des revendications précédentes, **caractérisé en ce que** le diapason piézoélectrique est un quartz dont les faces, supérieure (48) et inférieure (50), sont sensiblement perpendiculaires à l'axe optique (z) du quartz et **en ce que** les branches s'étendent sensiblement selon l'axe mécanique (y) du quartz.

8. Transducteur de mesure d'une vitesse angulaire selon l'une des revendications précédentes, **caractérisé en ce que** la base (22) est pourvue de moyens de découplage mécanique (45) entre la partie de fixation (46) de la base et les branches (23, 24) du diapason.

## Claims

1. Transducer for measuring an angular velocity formed by:
- a single piezoelectric tuning fork (21) that rotates at said angular velocity,
- said tuning fork including first (23) and second (24) vibrating legs extending from a base (22),
- means (25a, 25b, 26a, 26b) for exciting a first vibration of the tuning fork, arranged on one of the two legs, called the excitation leg (23),
- means (27a, 27b, 28a, 28b) for detecting a second vibration of the tuning fork generated in response to said first vibration and to a rotation of the tuning fork, arranged on the other of the two legs, called the detection leg (24),
**characterized in that** said detection leg (24) has a cross-shaped section including two top lateral faces (33, 34) and two bottom lateral faces (37, 38), said top and bottom faces being separated by protruding parts (41, 42) projecting with respect to said top and bottom faces, and
**in that** said detection means include first (27a) and second (28a) detection electrodes arranged facing each other, each being arranged on one of the top lateral faces (33, 34) such that the electrical field between the first and second detection electrodes is substantially rectilinear through the detection leg, and third (27b) and fourth (28b) detection electrodes arranged facing each other, each being arranged on one of the bottom lateral faces (37, 38) such that the electrical field between the third and fourth detection electrodes is substantially rectilinear through the detection leg.

2. Transducer for measuring an angular velocity according to claim 1, **characterized in that** said excitation leg (23) has a cross-shaped section including two top lateral faces (31, 32) and two bottom lateral faces (35, 36), said top and bottom faces being separated by first (39) and second (40) protruding parts projecting with respect to said top and bottom faces, and
**in that** said excitation means include a first pair of excitation electrodes (25a, 25b) arranged respectively on the top and bottom of the excitation leg, respectively covering the top lateral faces (31, 32) and bottom lateral faces (35, 36), and a second pair of excitation electrodes (26a, 26b), each of the electrodes of said second pair being arranged over the thickness of one (39) or the other (40) protruding part of the excitation leg.

3. Transducer for measuring an angular velocity according to claim 1, **characterized in that** said excitation leg (23) has a cross-shaped section including two top lateral faces (31, 32) and two bottom lateral faces (35, 36), said top and bottom faces being separated by first (39) and second (40) protruding parts projecting with respect to said top and bottom faces, and
**in that** said excitation means include a first pair of excitation electrodes (25a, 25b) arranged respectively on the top and bottom of the excitation leg, without covering the top lateral faces (31, 32) and bottom lateral faces (35, 36), and a second pair of excitation electrodes (26a, 26b), each of the electrodes of said second pair being arranged over the whole thickness of one (39), respectively the other (40) protruding part of the excitation leg as well as at least partially covering the top (31) and bottom (35) lateral faces arranged on either side of the first protruding part (39), respectively the top (32) and bottom (36) lateral faces arranged on either side of the second protruding part (40).

4. Transducer for measuring an angular velocity according to any of claims 1 to 3, **characterized in that** said cross-shaped section of the detection leg has a top face (48) connecting the two top lateral faces (33, 34) and a bottom face (50) connecting the two bottom lateral faces (37, 38),
**in that** said top and bottom faces each have at least one groove (55, 58; 59, 60), said grooves having lateral flanks,
**in that** at least one (27a) of the electrodes of said first pair of detection electrodes is arranged on one of the lateral flanks of said at least one groove (55; 59), of the top face such that the electrical field between the two electrodes (27a, 28a) is substantially rectilinear through the detection leg, and
**in that** at least one (27b) of the electrodes of the second pair of detection electrodes is arranged on one of the lateral flanks of said at least one groove (58; 60) of the bottom face such that the electrical field between the two electrodes (27b, 28b) is substantially rectilinear through the detection leg (24).

5. Transducer for measuring an angular velocity according to claim 4, **characterized in that** each of said top (48) and bottom (50) faces includes a single groove (59, 60),
**in that** said detection means further include a third pair (27c, 28c) of detection electrodes arranged facing each other, one (28c) of the electrodes of the third pair being arranged on the other lateral flank of said groove (59) of the top face, the other (27c) of the electrodes of the third pair being arranged on the top lateral face (34) such that the electrical field between the two electrodes (27c; 28c) is substantially rectilinear through the detection leg (24), and
**in that** the detection means further include a fourth pair of detection electrodes (27d, 28d) arranged facing each other, one (28d) of the electrodes of said fourth pair being arranged on the other lateral flank of said groove (60), the other (27d) of the electrodes of said fourth pair being arranged on the bottom lateral face (38) such that the electrical field between the two electrodes (27d, 28d) is substantially rectilinear through the detection leg.

6. Transducer for measuring an angular velocity according to claim 4, **characterized in that** each of the top (48) and bottom (50) faces includes two grooves (55-56, 57-58),
**in that** the detection means further include a third pair of electrodes (27c, 28c) arranged facing each other, one (28c) of the electrodes of said third pair being arranged on one lateral flank of the other of said grooves (56) of the top face, the other (27c) of the electrodes of said third pair being arranged on the top lateral face (34) such that the electrical field between the two electrodes (27c, 28c) is substantially rectilinear through the detection leg, and
**in that** the detection means further include a fourth pair of detection electrodes (27d, 28d) arranged facing each other, one (28d) of the electrodes of said fourth pair being arranged on one of the lateral flanks of the other of the two grooves (57) of the bottom face, the other (27d) of the electrodes of said fourth pair being arranged on the bottom lateral face (37) such that the electrical field between the two electrodes (27d, 28d) is substantially rectilinear through the detection leg.

7. Transducer for measuring an angular velocity according to any of the preceding claims, **characterized in that** the piezoelectric tuning fork is a quartz whose top (48) and bottom (50) faces are substantially perpendicular to the optical axis (z) of the quartz and **in that** the legs extend substantially along the mechanical axis (y) of the quartz.

8. Transducer for measuring an angular velocity according to any of the preceding claims, **characterized in that** the base (22) is provided with mechanical uncoupling means (45) between the part (46) for securing the base and the legs (23, 24) of the tuning fork.

## Patentansprüche

1. Sensor zum Messen einer Winkelgeschwindigkeit, gebildet von:
- einer einzigen piezoelektrischen Stimmgabel (21), die dazu bestimmt ist, sich mit dieser Winkelgeschwindigkeit zu drehen;
- wobei diese Stimmgabel erste (23) und zweite (24) schwingende Arme umfasst, die sich von einer Basis (22) aus erstrecken;
- Mittel (25a, 25b, 26a, 26b) zum Anregen einer ersten Schwingung der Stimmgabel, die auf einem der beiden Arme angeordnet sind, der als Anregungsarm (23) bezeichnet wird;
- Mittel (27a, 27b, 28a, 28b) zum Detektieren einer als Antwort auf die erste Schwingung und auf eine Drehung der Stimmgabel erzeugten zweiten Schwingung der Stimmgabel, wobei diese Mittel auf dem anderen der beiden Arme angeordnet sind, der als Detektionsarm (24) bezeichnet wird;
- **dadurch gekennzeichnet, dass** der Detektionsarm (24) einen kreuzförmigen Querschnitt aufweist, der zwei obere seitliche Flächen (33, 34) und zwei untere seitliche Flächen (37, 38) umfasst, wobei diese oberen und unteren Flächen von in Bezug auf diese oberen und unteren Flächen vorstehenden Vorsprüngen (41, 42) voneinander getrennt sind, und
dass die Mittel zum Detektieren eine erste (27a) und eine zweite (28a) einander gegenüberliegend angeordnete Detektionselektrode umfassen, wobei jede auf einer der oberen seitlichen Flächen (33, 34) derart angeordnet ist, dass das elektrische Feld zwischen der ersten und der zweiten Detektionselektrode im Wesentlichen geradlinig durch den Detektionsarm verläuft, und dritte(27b) und vierte (28b) einander gegenüberliegend angeordnete Detektionselektroden umfassen, wobei jede auf einer der unteren seitlichen Flächen (37, 38) derart angeordnet ist, dass das elektrische Feld zwischen der dritten und der vierten Detektionselektrode im Wesentlichen geradlinig durch den Detektionsarm verläuft.

2. Sensor zum Messen einer Winkelgeschwindigkeit nach Anspruch 1, **dadurch gekennzeichnet, dass** der Anregungsarm (23) einen kreuzförmigen Querschnitt aufweist, der zwei obere seitliche Flächen (31, 32) und zwei untere seitliche Flächen (35, 36) umfasst, wobei die oberen und unteren Flächen von einem ersten (39) und einem zweiten (40) in Bezug auf die oberen und unteren Seiten überstehenden Vorsprung voneinander getrennt sind, und,
dass die Mittel zum Anregen ein erstes Paar Anregungselektroden (25a, 25b) umfassen, die auf bzw. unter dem Anregungsarm angeordnet sind, wobei sie die oberen (31, 32) bzw. unteren (35, 36) seitlichen Flächen bedecken, und sie ein zweites Paar Anregungselektroden (26a, 26b) umfassen, wobei jede Elektrode des zweiten Paares über die gesamte Dicke des einen (39) bzw. des anderen (40) Vorsprungs des Anregungsarmes ausgebildet ist.

3. Sensor zum Messen einer Winkelgeschwindigkeit nach Anspruch 1, **dadurch gekennzeichnet, dass** der Anregungsarm (23) einen kreuzförmigen Querschnitt aufweist, welcher zwei obere seitliche Flächen (31, 32) und zwei untere seitliche Flächen (35, 36) umfasst, wobei diese oberen und unteren Flächen von einem ersten (39) und einem zweiten (40) in Bezug auf diese oberen und unteren Seiten vorstehenden Vorsprung voneinander getrennt sind, und,
dass die Mittel zum Anregen ein erstes Paar Anregungselektroden (25a, 25b) umfassen, die über bzw. unter dem Anregungsarm angeordnet sind, ohne die oberen seitlichen Flächen (31, 32) bzw. die unteren seitlichen Flächen (35, 36) zu bedecken, und sie ein zweites Paar Anregungselektroden (26a, 26b) umfassen, wobei jede Elektrode des zweiten Paares über die gesamte Dicke des einen (39) bzw. des anderen (40) Vorsprungs des Anregungsarms ausgebildet ist und wenigstens teilweise die obere seitliche Fläche (31) und die untere seitliche Fläche (35), die sich auf der einen und auf der anderen Seite des ersten Vorsprungs (39) befinden, bzw. die obere seitliche Fläche (32) und die untere seitliche (36) Fläche, die sich auf der einen und anderen Seite des zweiten Vorsprungs (40) befinden, verdecken.

4. Sensor zum Messen einer Winkelgeschwindigkeit nach einem der Ansprüche 1 bis 3, **dadurch gekennzeichnet, dass** der kreuzförmige Querschnitt des Detektionsarmes eine die beiden oberen seitlichen Flächen (33, 34) verbindende obere Fläche (48) und eine die beiden unteren seitlichen Flächen (37, 38) verbindende untere Fläche (50), aufweist
dass die obere und untere Fläche jeweils wenigstens eine Nut (55, 58; 59, 60) aufweist, wobei diese Nuten seitliche Flanken aufweisen,
dass wenigstens die eine (27a) der Elektroden des ersten Paares von Detektionselektroden auf einer der seitlichen Flanken von der wenigstens einen Nut (55; 59) der oberen Fläche so angeordnet ist, dass das elektrische Feld zwischen den beiden Elektroden (27a, 28a) im wesentlichen geradlinig durch den Detektionsarm verläuft, und,
dass wenigstens die eine (27b) der Elektroden des zweiten Paares von Detektionselektroden auf einer der seitlichen Flanken der wenigsten einen Nut (58; 60) der unteren Fläche so angeordnet ist, dass das elektrische Feld zwischen den beiden Elektroden (27b, 28b) im Wesentlichen geradlinig durch den Detektionsarm (24) verläuft.

5. Sensor zum Messen einer Winkelgeschwindigkeit nach Anspruch 4, **dadurch gekennzeichnet, dass** sowohl die obere (48) als auch die untere (50) Fläche jeweils nur eine Nut (59, 60) umfasst,
dass die Mittel zum Detektieren ferner ein drittes Paar (27c, 28c) von einander gegenüberliegend angeordneten Detektionselektroden umfassen, wobei die eine (28c) Elektrode des dritten Paares auf der anderen Seitenflanke der Nut (59) der oberen Fläche angeordnet ist, und die andere (27c) Elektrode des dritten Paares auf der oberen seitlichen Fläche (34) so angeordnet ist, dass das elektrische Feld zwischen den beiden Elektroden (27c, 28c) im Wesentlichen geradlinig durch den Detektionsarm (24) verläuft, und,
dass die Mittel zum Detektieren ferner ein viertes Paar einander gegenüber liegend angeordnete Detektionselektroden (27d, 28d) umfassen, wobei die eine (28d) Elektrode des vierten Paares auf der anderen seitlichen Flanke der Nut (60) der unteren Seite angeordnet ist, und die andere (27d) Elektrode des vierten Paares auf der unteren seitlichen Fläche (38) so angeordnet ist, dass das elektrische Feld zwischen den beiden Elektroden (27d, 28d) im Wesentlichen geradlinig durch den Detektionsarm verläuft.

6. Sensor zum Messen einer Winkelgeschwindigkeit nach Anspruch 4, **dadurch gekennzeichnet, dass** sowohl die obere Fläche (48) als auch die untere Fläche (50) jeweils zwei Nuten (55 - 56, 57 - 58) umfasst,
dass die Mittel zum Detektieren ferner ein drittes Paar Elektroden (27c, 28c) umfassen, das auf einer der seitlichen Flanken der anderen der zwei Nuten (56 der oberen Fläche angeordnet ist, wobei die andere (27c) Elektrode des dritten Paares auf der oberen seitlichen Fläche (34) derart angeordnet ist, dass das elektrische Feld zwischen den beiden Elektroden (27c, 28c) im Wesentlichen geradlinig durch den Detektionsarm verläuft, und,
dass die Mittel zum Detektieren ferner ein viertes Paar von einander gegenüberliegend angeordneten Detektionselektroden (27d, 28d) umfassen, wobei die eine (28d) Elektrode des vierten Paares auf der einen seitlichen Flanke der anderen der zwei Nuten (57) der unteren Fläche angeordnet ist, und die andere (27d) Elektrode des vierten Paares auf der unteren seitlichen Fläche (37) derart angeordnet ist, dass das elektrische Feld zwischen den beiden Elektroden (27d, 28d) im Wesentlichen geradlinig durch den Detektionsarm verläuft.

7. Sensor zum Messen einer Winkelgeschwindigkeit nach einem der vorstehenden Ansprüche, **dadurch gekennzeichnet, dass** die piezoelektrische Stimmgabel ein Quarz ist, dessen obere (48) und untere (50) Seiten im Wesentlichen senkrecht zur optischen Achse (7) des Quarzes sind, und dass die Arme sich im Wesentlichen in Richtung der mechanischen Achse (y) des Quarzes erstrecken.

8. Sensor zum Messen einer Winkelgeschwindigkeit nach einem der vorstehenden Ansprüche, **dadurch gekennzeichnet, dass** die Basis (22) mit Mittelns zur mechanischen Entkopplung (45) zwischen dem Befestigungsteil (46) der Basis und den Armen (23, 24) der Stimmgabel versehen ist.
